# EUROPEAN PATENT APPLICATION

(11) **EP 4 803 652 A1**
(43) Date of publication of application: **09.09.2026**
(21) Application number: 25161521.7
(22) Date of filing: 04.03.2025
(51) Int. Cl.: C23C 14/00, C23C 14/24, C23C 14/34, C23C 14/35, C23C 14/56, H01J 37/34

(54) **METHOD AND COATING ARRANGEMENT FOR COATING A METALLIC SUBSTRATE**

(71) Applicant: NEOVAC GmbH, 63791 Karlstein (DE)
(72) Inventor: HERZOG, André, 63791 Karlstein (DE); ENGLERT, Ulrich, 63791 Karlstein (DE)
(74) Representative: Weilnau, Carsten

(57) **Abstract**

The present disclosure relates to a coating arrangement (1) for coating a metallic substrate (10) extending along a longitudinal direction (x), the coating arrangement (1) comprising:
- a vacuum chamber (2) to receive the metallic substrate (10),
- an evaporation device (20) arranged inside the vacuum chamber (2) and configured to evaporate an evaporation material (17), the evaporation device (20) comprising a vapor outlet (28) extending in a transverse direction (y) relative to the longitudinal direction (x) to direct a vapor cloud (19) towards the substrate (10),
- a first magnetron sputter source (40) arranged inside the vacuum chamber (2) longitudinally adjacent to the vapor outlet (28) and configured to generate a plasma (52) of a plasma material within a plasma zone (54), and
- wherein the evaporation device (20) and the first magnetron sputter source (40) are configured such, that the vapor cloud (19) and the plasma zone (54) at least partially overlap.

## Description

The present invention relates to the field of coating substrates, and in particular to the field of coating metallic substrates with a metallic coating or anti-corrosive coating. In further aspects the present invention relates to methods and coating arrangements for coating a metallic substrate, e.g. for continuously coating a movable substrate inside an evaporation or vacuum chamber.

### Background

Coating materials, such as a gaseous metal or metallic layers may be coated on a surface of a metallic substrate, such as a single sheet or steel strip. Here, the substrate is arranged in a coating- or vacuum atmosphere. In vacuum deposition there may be applied various deposition methods, by way of which a solid or liquid coating material, e.g. a metallic coating material, is evaporated. This typically implies a heating of the evaporation material up to an evaporation temperature, e.g. in a vacuum atmosphere, to transition into a gaseous or evaporated state. Once the evaporation material is sufficiently evaporated a thin-film is formed on the substrate as a coating.

Typically and for physical vapor deposition (PVD) of substrates on a rather large scale it is quite challenging to precisely control a deposition process inside the vacuum atmosphere. It is also quite challenging to control a geometric expansion of evaporated material inside a vacuum chamber.

For obtaining an optimal anticorrosive coating on a metallic substrate, it may be desirable to apply a coating system comprising numerous layers of different coating materials. Also, and during the coating process the metallic substrate should not be exposed to overly high temperatures or thermal loads. On the other hand, conducting a coating at comparatively low temperatures may be detrimental to the quality of the coating. Moreover, when applying a multi-layer coating or when applying layers of different materials onto the surface of the substrate, the mutual adhesion of the individual layers as well as the stoichiometric composition of the layers may be difficult to control.

Since different materials to be coated on the metallic substrate typically exhibit different melting points the combination of a variety of different materials on the substrate may require implementation of numerous evaporation devices inside the vacuum chamber, each of which providing a vapor of a single material. This makes the process of coating control rather difficult and complicated.

It is therefore desirable to provide improvements to methods and coating arrangements for coating metallic substrates with numerous layers of different materials. The coating arrangement should be easily controllable both, during operation as well as during and/or for maintenance. The coating arrangement should provide excellent and/or improved coating surface qualities and should further provide improved adhesion of individual coating layers among each other as well as to the substrate, even when the coating process is conducted at comparatively low temperatures. Moreover, the coating arrangement should provide a rather cost- and time efficient coating of moving metallic substrates on a comparatively large scale.

### Summary

In one aspect there is provided a coating arrangement for coating a metallic substrate extending along a longitudinal direction (x). The metallic substrate may comprise an endless band of a metallic material. The metallic substrate may comprise a band or strip of steel.

The coating arrangement comprises a vacuum chamber to receive the metallic substrate. The coating arrangement further comprises an evaporation device arranged inside the vacuum chamber and configured to evaporate an evaporation material. The evaporation device comprises a vapor outlet extending in a transverse direction (y) relative to the longitudinal direction to direct a vapor cloud and/or a vapor beam towards the substrate.

The coating arrangement further comprises a first magnetron sputter source arranged inside the vacuum chamber longitudinally adjacent to the vapor outlet. The first magnetron sputter source is configured to generate a plasma of a plasma material within a plasma zone. The evaporation device and the first magnetron sputter source are configured and/or arranged such that the vapor cloud and the plasma zone at least partially overlap.

The combination of an evaporation device with at least a first magnetron sputter source provides numerous benefits for coating of the metallic substrate. The magnetron sputter source may provide a deposition of a sputter material on the surface of the metallic substrate.

The evaporation device may provide a vapor deposition of a further material, i.e. of the evaporation material on the same surface of the metallic substrate. In this way, there can be provided a simultaneous and/or temporally overlapping deposition of numerous materials on the same side of a metallic substrate.

Moreover, by combining the process of a vapor deposition by way of the evaporation device with a sputter deposition as provided by the first magnetron sputter source, the quality of the coating on the metallic substrate can be improved. Specifically, the surface quality of the coating on the metallic substrate as well as the adhesion of the coating material on the metallic substrate can be improved at comparatively low process or coating temperatures.

Hence, the combination of physical vapor deposition by way of the evaporation device and the sputter deposition as provided by the first magnetron sputter source is beneficial to obtain surface coatings on the metallic substrate of high quality at comparatively low temperatures. Here, the thermal load presents to the metallic substrate during the coating process can be kept at a comparatively low level. This allows to coat and/or to treat metallic substrates that are not suitable for exposure to comparatively high process temperatures or comparatively high thermal loads.

Moreover, the at least partial spatial overlapping of the vapor cloud or vapor beam as generated by the evaporation device with the plasma zone of the magnetron sputter source provides an interaction of the vaporized evaporation material with the plasma in the plasma zone. This mutual interaction has turned out to provide numerous benefits in terms of surface quality and composition of the coating on the metallic substrate.

Moreover, and since the vapor outlet of the evaporation device extends in a transverse direction with respect to the longitudinal direction there may be provided a homogeneous spatial distribution of the vaporized evaporation material along the transverse direction and hence across the metallic substrate perpendicular to the longitudinal direction of the metallic substrate.

According to some examples, the transverse extent of the vapor outlet of the evaporation device is substantially identical or somewhat equivalent to the width of the metallic substrate as seen in the transverse direction. In this way, the entire width of the metallic substrate, i.e., the dimension of the metallic substrate that extends perpendicular to its longitudinal direction can be homogeneously exposed to the vaporized evaporation material emanating from vapor outlet of the evaporation device.

According to some examples the evaporation device comprises or constitutes a line evaporator. Here, the vapor outlet of the evaporation device may be characterized by a longitudinal slit or longitudinal aperture through which the vaporized evaporation material may escape from an interior of the evaporation device towards and onto the metallic substrate. The elongated slit or elongated aperture of the vapor outlet may extend along or parallel to the transverse direction, i.e., perpendicular to the longitudinal direction or longitudinal extent of the metallic substrate. In this way, the entire width of the metallic substrate can be exposed to a rather homogeneous vapor distribution.

Moreover, and according to some examples the coating arrangement may be configured for a continuous coating of the entire surface of the metallic substrate. Hence, the coating arrangement may comprise a substrate transport arrangement by way of which the metallic substrate can be continuously moved along the longitudinal direction relative to the evaporation device and relative to the first magnetron sputter source. In this way there can be provided a continuous coating of the entire surface of the metallic substrate as the metallic substrate is subject to a longitudinal displacement relative to the evaporation device and relative to the first magnetron sputter source.

The evaporation device and the first magnetron sputter source may be stationary. They may be spatially fixed relative to each other.

According to some examples, at least one of the evaporation device and the first magnetron sputter source is configurable or reconfigurable or usable so as to modify or tune at least one of a direction, a size, a spatial extent and/or a spatial shape of the vapor cloud and/or of the plasma zone.

According to some examples the plasma zone may effectively cover or screen the vapor outlet of the evaporation device. Hence, the evaporation device and the first magnetron sputter source may be arranged and configured such that the evaporated evaporation material extending into the vapor cloud or forming the vapor cloud has to traverse the plasma zone before reaching the surface of the metallic substrate. In this way, it may be provided that the beam or cloud of vapor emanating from the vapor outlet has to interact with the plasma zone and hence with the plasma located in the plasma zone.

Here, vaporized particles of the evaporation material, i.e. atoms of the evaporation material may be ionized as the vapor cloud traverses the plasma zone. Respective ions of the evaporation material may then interact with the magnetic field of the first magnetron sputter source. This interaction may provide a kind of a magnetic lens effect by way of which the spatial extent of the evaporation material can be controlled and influenced by the magnetic field of the first magnetron sputter source so as to improve the properties of the resulting coating on the metallic substrate.

According to some examples the metallic substrate may be electrically connected to ground. Since the plasma as generated by the first magnetron sputter source is electrically charged and exhibits a respective electrical impedance, there will be provided a kind of a self-bias effect due to the potential difference between the plasma zone and the surface of the substrate.

Insofar and due to such a self-bias voltage on the surface of the substrate the ions of the evaporation material may experience a supplemental attractive electrical force towards the substrate, which may further improve the quality and the respective properties of the coating on the substrate.

The electric potential of this self-bias can be controlled and varied by modifying the gas pressure in the vacuum chamber, by modifying and controlling the power of the first magnetron sputter source as well as by modifying the evaporation rate of the evaporation device.

In addition to the generation of a plasma of a plasma material, the first magnetron sputter source may of course also provide a first target for sputter deposition. The first target may comprise a first electrode made of or comprising a respective first sputter material. Ions of the plasma in the plasma zone can be accelerated towards the sputter target so as to collide with surface atoms on the sputter target to extract or detach respective atoms from the surface of the sputter target to finally generate a sputter zone of sputtered material directed towards the metallic substrate.

Sputtered material as extracted from the sputter target may then propagate through the sputter zone towards and onto the metallic substrate. The material of the sputter target and hence the sputter material may be identical to the evaporation material as provided by the evaporation device and as emanating through the vapor outlet. In this way, the deposition rate of the evaporation material on the metallic substrate can be increased by the sputter process.

In some examples, the material of the sputter target may distinguish from the material of the evaporation device and hence from the evaporation material. In this way, numerous or different materials can be deposited on the metallic substrate simultaneously or in a temporal overlapping manner. Accordingly, the coating on the metallic substrate may comprise numerous materials or numerous layers of different materials. Also, the stoichiometric composition of the coating on the metallic substrate can be easily varied and controlled by controlling or modifying the sputter process as conducted by the first magnetron sputter source and by controlling or modifying the evaporation process by the evaporation device.

In general, the overall power of the magnetron sputter device, the gas pressure inside the vacuum chamber, i.e., the gas pressure of an inert gas for plasma generation, a driving voltage, i.e., high-frequency, or a pulsed operation of the at least first magnetron sputter source as well as a spatial extent, shape and direction of the plasma zone and/or of the vapor zone can be adapted and controlled to provide a coating on the metallic substrate of desired quality and properties.

According to a further example the evaporation device comprises a housing confining an evaporation cavity. The vapor outlet comprises an elongated nozzle, which is in flow communication with the evaporation cavity and which extends in the transverse direction. The elongated nozzle and/or the vapor outlet comprises an elongated aperture through which the vaporized evaporation material may emanate from the evaporation cavity confined by the housing of the evaporation device, into the vacuum chamber outside the housing of the evaporation device. The outlet, nozzle or aperture of the evaporation device may comprise a constant cross-section as seen in the transverse direction (y), hence along the elongation of the elongated nozzle.

In this way, there can be provided a rather homogeneous composition, density, shape and size of the respective vapor cloud as seen in the transverse direction, i.e., along the elongation of the elongated nozzle. This provides a rather homogeneous vapor deposition on the surface of the metallic substrate as seen in the transverse direction (y).

Typically, the evaporation device and hence the housing of the evaporation device comprises a heating. A lower portion of the housing is configured to receive a molten or meltable evaporation material, which due to the thermal heating as provided by the housing of the evaporation device, transitions into a respective steam or vapor, which is allowed to escape from the evaporation cavity through the vapor outlet and hence through the elongated nozzle of the vapor outlet towards the metallic substrate.

The elongated nozzle may be located in one of a top wall of the housing of the evaporation device or at an upper end of a sidewall of the housing of the evaporation device. The vapor outlet may be oriented vertically. Hence the vapor outlet may point in an upward direction thus producing a vertically and upwardly directed vapor cloud.

With other examples, and when the vapor outlet points horizontally or at a particular angle with respect to the horizontal or vertical axes, the vapor cloud may extend horizontally or at a particular angle with respect to the horizontal direction. The latter case and specifically when the vapor outlet points horizontally the coating arrangement may be particularly suitable for coating a metallic substrate that is oriented vertically, and/or for coating a metallic substrate that is subject to a vertically directed movement relative to the evaporation device. Here, both opposite surfaces of the metallic substrate may be coated simultaneously by a first coating arrangement facing one side of the metallic substrate and by another coating arrangement facing an opposite side of the metallic substrate.

According to a further example the first magnetron sputter source comprises a hollow tubular sleeve with a sleeve axis extending in the transverse direction. In some examples the hollow tubular sleeve may comprise a longitudinal extend that is substantially equivalent or which corresponds to the transverse dimensions of the metallic substrate. In this way, the first magnetron sputter source may be configured to generate a plasma and hence a plasma zone that is substantially homogeneous across the transverse extent of the metallic substrate. In this way, the plasma and the plasma zone may comprise equal or constant properties as seen in the transverse direction.

The hollow tubular sleeve may comprise or constitute an electrode of the first magnetron sputter source. In some examples, the hollow tubular sleeve may form or constitute a target of the first magnetron sputter source.

According to another example the first magnetron sputter source comprises a first rotatable sputter target, which is rotatable with respect to a first axis of rotation extending in the transverse direction. A rotatable sputter target, which is rotatable with respect to a first axis of rotation extending in the transverse direction, is of particular benefit to provide a plasma and a plasma zone as well as a first sputter zone of a first sputter material that is somewhat homogeneous as seen in along the transverse direction. This helps to provide a rather homogeneous coating on the metallic substrate as seen in the transverse direction, i.e., perpendicular to the longitudinal direction or extent of the metallic substrate.

According to some examples the hollow tubular sleeve forms or constitutes the first rotatable sputter target. Hence, the first rotatable sputter target may coincide with the hollow tubular sleeve as described above. The first rotatable sputter target of the first magnetron sputter source may comprise the hollow tubular sleeve with a central sleeve axis extending in the transverse direction. The first rotatable sputter target and hence the hollow tubular sleeve may be rotatable with respect to the first axis of rotation, which may coincide with the above-mentioned sleeve central axis.

A rotatable sputter target may be continuously rotatable during the coating process. Insofar, the sputtering or removal of material from the sputter target continuously rotates across the rotating sputter target. Here, zones of redeposition of sputtered material on the target can be reduced or entirely eliminated. Moreover, the entire sputter process can be easily controlled with a rotating sputter target.

According to a further example the first magnetron sputter source comprises a first magnet arrangement inside the first rotatable sputter target and/or inside the hollow tubular sleeve. The first magnet arrangement may comprise one or a number and hence an arrangement of permanent magnets. The magnets serve to induce a helical motion of the free electrons of the plasma in the plasma zone to induce collisions with atoms of an inert gas, such as argon, provided inside the vacuum chamber at a predefined partial gas pressure.

The first rotatable sputter target may comprise or provide a sputter electrode and may be operated at a predefined DC or AC voltage. Ions of the plasma or plasma zone will be accelerated towards the first rotatable sputter target in order to collide with the surface atoms provided on the sputter target thereby releasing and/or extracting sputter material from the sputter target towards and into the sputter zone and hence towards and onto the metallic substrate.

The first magnet arrangement serves to control and/or to manipulate at least one of the the position, the size, the shape and the direction of the plasma zone as well as of a sputter zone of sputtered material released from the surface of the first rotatable sputter target.

According to a further example the magnet arrangement is movable, e.g., rotatable or tiltable relative to at least one of the first rotatable sputter target and the hollow tubular sleeve with respect to a tilt axes. The tilt axis extends in the transverse direction. The tilt axis may coincide with at least one of the sleeve axis of the hollow tubular sleeve of the first magnetron sputter source and the first axis of rotation of the first rotatable sputter target. The tilt axis does not necessarily have to coincide with any of these above-mentioned axes.

However, the tilt axis may extend parallel to at least one of the rotation axis of the first rotatable sputter target and the central axis of the hollow tubular sleeve. In this way, an angle of incidence of the sputter zone relative to the surface normal of the metallic substrate as well as an angle of incidence of the sputter zone with respect to the main direction of the vapor cloud can be adjusted. By way of tilting or reorienting the magnet arrangement of the first magnetron sputter source, the degree of spatial overlapping and/or mutual penetration of the vapor cloud and the plasma zone can be adjusted and modified in order to optimize the coating on and/or the coating process of the metallic substrate.

According to a further example the first rotatable sputter target comprises a first sputter material and the first magnetron sputter source is configured to generate a first sputter zone extending towards the substrate and including first sputtered material extracted from the first rotatable sputter target. Accordingly, the first magnetron sputter source may provide a supplemental coating of the metallic substrate in addition to the physical vapor deposition as provided by the evaporation device of the coating arrangement.

The sputter material may be identical to the evaporation material. In this way, the deposition rate of one and the same coating material on the metallic substrate can be increased while keeping the process temperature of the metallic substrate at a comparatively low level. In further examples, the sputter material distinguishes from the evaporation material. In this way, there can be generated and provided a coating on the metallic substrate comprising first and second layers of different materials.

Here, one layer of the coating may be provided by the physical vapor deposition and another layer of the coating may be provided by the sputter deposition as provided by the first magnetron sputter source. Depending on the degree of overlap between the plasma zone, the vapor cloud and the sputter zone there can be also provided coatings on the metallic substrate comprising or including a mixture of different coating materials. Moreover, and by controlling and/or varying the degree of spatial overlap between the vapor cloud and the sputter zone, between the vapor cloud and the plasma zone and/or between the plasma zone and the sputter zone, the stoichiometric composition of the coating on the metallic substrate can be varied and controlled quite universally and in a rather flexible way.

Use of the first magnetron sputter source with a rotatable sputter target and with a rotatable or tiltable magnet arrangement provides the benefit to vary the orientation and/or direction of the first sputter zone as well as the orientation, size and spatial extent of the plasma zone without the necessity to rearrange or to vary the relative position between the evaporation device and the first magnetron sputter source.

Since the first magnet arrangement is located inside the first rotatable sputter target it is inherently protected against contamination or redeposition of vaporized or sputtered material. This provides a rather long-lasting and maintenance-free operation of the entire coating arrangement.

According to a further example the coating arrangement further comprises a second magnetron sputter source arranged inside the vacuum chamber longitudinally adjacent to the vapor outlet such that the vapor outlet is located longitudinally between the first magnetron sputter source and the second magnetron sputter source.

The first magnetron sputter source and the second magnetron sputter source may be implemented rather identically. Hence, the hardware components of the second magnetron sputter source and the hardware components of the first magnetron sputter source may be equivalent or identical.

The vapor outlet of the evaporation device may be located midway between the first magnetron sputter source and the second magnetron sputter source as seen in longitudinal direction. The distance between the first and the second sputter sources to the metallic substrate with respect to a surface normal of the metallic substrate may be equivalent or substantiality identical. In this way, the first sputter zone as generated by the first magnetron sputter source and a second sputter zone as generated or provided by the second magnetron sputter source may be somewhat identical or similar. With respect to the direction of the surface normal of the substrate the first and the second magnetron sputter source may be configured or oriented somewhat mirror symmetric.

In other examples the configuration of the first magnetron sputter source and the configuration of the second magnetron sputter source may distinguish from each other.

According to some examples the second magnetron sputter source also comprises a hollow tubular sleeve with a sleeve axis extending in the transverse direction (y). In some examples, the second magnetron sputter source also comprises a second rotatable sputter target, which is rotatable with respect to a second axis of rotation extending in the transverse direction. In further examples, the second magnetron sputter source comprises a second magnet arrangement inside the second rotatable sputter target and/or inside the hollow tubular sleeve of the second magnetron sputter source.

Also here, the second magnet arrangement may be rotatable or tiltable relative to at least one of the second rotatable sputter target and the hollow tubular sleeve of the second magnetron sputter source with respect to a tilt axis extending in the transverse direction.

In some examples, the first magnetron sputter source and the first rotatable sputter target extend parallel to the second magnetron sputter source and/or parallel to the second rotatable sputter target. In this way, both magnetron sputter sources may provide a rather constant and/or homogeneous plasma zone extending in transverse direction across the metallic substrate or in a predefined distance from the metallic substrate. In addition, the first magnetron sputter source and the second magnetron sputter source may serve to provide a respective first sputter zone and a respective second sputter zone, wherein the first sputter zone and the second sputter zone may extend homogeneously along the transverse direction (y) as seen with respect to the elongation or moving direction (x) of the metallic substrate.

Providing of a second magnetron sputter source at a well-defined position or distance from the first magnetron sputter source may be beneficial to generate the plasma and the plasma zone between first and second magnetron sputter sources. Here, the plasma of the plasma material may be generated between the first electrode of the first magnetron sputter source and a second electrode of the second magnetron sputter source. Respective electrodes of the first and the second magnetron sputter sources may be driven by a power source, such as an AC voltage generator.

The respective first and second electrodes of the first and second magnetron sputter sources may be operated at a RF AC voltage. Accordingly, the first and second electrodes of first and second magnetron sputter sources may be driven by a sinusoidal AC voltage or by one of a bipolar or unipolar pulsed alternating voltage. Here, frequency, pulse duration, pulse amplitude and pulse intervals may be controlled and varied by the power source and hence by the AC voltage generator in order to produce or to generate a plasma and/or a plasma zone of desired strength, density, size and/or shape or contour, which is beneficial for providing a coating on the metallic substrate of desired quality and properties.

Accordingly and with a further example a first electrode of the first magnetron sputter source and a second electrode of the second magnetron sputter source are electrically coupled to an AC power source to generate an electrical field of alternating polarity between the first electrode and the second electrode. Accordingly, and with the AC voltage applied between first and second electrodes of the first and second magnetron sputter sources, the plasma and hence the plasma zone may extend between the first and second rotatable sputter target, which are arranged at a longitudinal distance with respect to each other.

In some examples the evaporation device is located longitudinally between the first and the second rotatable sputter targets. Generating the plasma and the plasma zone between the first and the second magnetron sputter sources, specifically between the first and the second rotatable sputter targets, there can be provides a plasma zone that extends from the first magnetron sputter source to the second magnetron sputter source. With the evaporation device located between the first and the second rotatable sputter sources and hence between the first and the second rotatable sputter targets the vapor escaping from or through the vapor outlet has to penetrate or to traverse the plasma zone before reaching the metallic substrate.

Accordingly, and in some examples the distance between the first and/or the second magnetron sputter sources to the metallic substrate may be smaller than the respective distance between the vapor outlet and the metallic substrate. As seen along the surface normal of the metallic substrate, the plasma zone may be located closer to the surface of the metallic substrate than the vapor outlet, such that the vapor emanating from the vapor outlet has to traverse and/or to intersect the plasma zone.

According to a further example the second magnetron sputter source comprises a second sputter target comprising a second sputter material, which distinguishes from the first sputter material of the first magnetron sputter source. The second sputter material may also distinguish from the evaporation material.

In this way, there can be provided a coating on the metallic substrate comprising three layers of different materials or a coating with three regions of different stoichiometric composition. Especially and with a moving metallic substrate moving along the longitudinal direction and with a respective longitudinal offset or distance between the first magnetron sputter source, the evaporation device and the second magnetron sputter source, there can be provided a coating on the metallic substrate that is composed of the first sputter material provided on the surface of the metallic substrate.

The evaporation material may be located on top of the first sputter material and there may be further provided the second sputter material on top of the evaporation material.

Accordingly, and as seen in the moving direction of the metallic substrate relative to the evaporation device and the first and second magnetron sputter sources, there may be first provided the first magnetron sputter source followed by the evaporation device followed by the second magnetron sputter source. Here, and as seen in the moving direction of the metallic substrate or as seen along the longitudinal direction of the metallic substrate, during the coating process the metallic substrate may be exposed to the first sputter zone emanating from the first magnetron sputter device. It may be then exposed to the vapor cloud that penetrates or traverses the plasma zone and it may be then exposed to the second sputter zone emanating from or generated by the second magnetron sputter source. Depending on the spatial overlap and/or mutual penetration between the first sputter zone, the vapor cloud or vapor zone and the second sputter zone, the stoichiometric composition of the coating can be controlled and modified in accordance to predefined requirements.

According to a further example a transverse extent of at least one of the vapor outlet and the magnetron sputter source corresponds to a transverse extent of the substrate. The respective elongation or extent of the vapor outlet and/or of the magnetron sputter source may be slightly larger than the respective transverse extent of the metallic substrate. In this way, the entire width of the metallic substrate can be homogeneously provided with a coating and can be homogeneously coated by way of the vapor cloud emanating from the evaporation device and by way of the sputter materials emanating from the first and the second magnetron sputter sources, respectively.

According to a further example the coating arrangement comprises a substrate transportation arrangement to move the substrate along the longitudinal direction relative to the evaporation device and relative to the first magnetron sputter source and/or relative to the second magnetron sputter source. The substrate transportation arrangement may be configured to continuously move the substrate along the longitudinal direction relative to the evaporation device and relative to the first and second magnetron sputter sources.

According to another example the longitudinal extent of the substrate is oriented vertically as seen with respect to the direction of gravity. The evaporation device is then located at a horizontal offset to a first side of the substrate. Here, the vapor outlet may extend towards a horizontal direction and/or the vapor outlet comprises at least a component facing in horizontal direction so as to direct the vapor cloud substantially horizontally or under a predefined angle onto the vertically oriented substrate.

Likewise, the orientation of the first magnetron sputter source and the optional second magnetron sputter source may be adjusted accordingly. The vertical orientation of the substrate may provide a rather well-defined and homogeneous coating on the surface of the metallic substrate which is effectively void of the influence of gravity.

The vertical orientation of the longitudinal extent of the substrate during the coating process or while passing the coating arrangement provides the benefit to apply a respective coating on both opposite sides of the metallic substrate. Here, there may be provided an another evaporation device at a horizontal offset to a second side, e.g. an opposite side of the substrate, which is opposite the first side. In addition, there may be also provided another first magnetron sputter source at a horizontal offset to the second side of the substrate opposite the first side. There may be also provided another second magnetron sputter source at a horizontal offset to the second side of the substrate opposite the first side.

Hence, the entire coating arrangement as described above with respect to one side of the metallic substrate may be duplicated and may be provided on the opposite side of the metallic substrate. This allows to simultaneously coat both sides of the substrate in a somewhat identical manner. In this way, the coating efficiency and the deposition rate for opposite sides of the metallic substrates can be improved and hence even complicated.

The size, configuration and arrangement of the coating arrangement provided on one side of the substrate may be substantially identical to the respective size, arrangement and configuration of the another coating arrangement provided on the opposite side of the metallic substrate. Insofar, all effects, features and benefits described above in connection with the evaporation device, the first magnetron sputter source and the second magnetron sputter source may equally apply to the another evaporation device, the another first magnetron sputter source and the another second magnetron sputter source provided on the opposite side of the metallic substrate.

The metallic substrate may comprise an endless band or strip of metallic material, such as a band of steel. The metallic substrate may comprise a high-strength steel, e.g. a high-strength low-alloy steel, e.g., a martensitic steel, and the coating applied to the metallic substrate may be an anticorrosive coating. The coating materials may comprise at least one of the zinc, aluminum and magnesium.

According to some examples, the evaporation material is or comprises zinc. According to further examples, the first sputter material is or comprises aluminum and the second sputter material is or comprises magnesium or titanium. According to some examples, the coating applied on the metallic substrate by the coating arrangement as described herein comprises a layer of aluminum or a layer that is dominated by aluminum and which is directly provided on the surface of the metallic substrate. The aluminum layer may provide or constitute a barrier layer that serves to improve the malleability of the metallic substrate.

The second layer, made of, comprising or being dominated by the evaporation material may comprise zinc as an anticorrosive layer. Finally, the third layer of the coating may be provided or dominated by the second sputter material, which may be selected from magnesium or titanium. By way of the third layer, the effect of corrosion protection can be even increased or improved.

In another aspect the present disclosure also relates to a method of coating a metallic substrate extending along a longitudinal direction by using a coating arrangement. The method comprises the steps of supplying the metallic substrate in a vacuum chamber of the coating arrangement. In a further step an evaporation material is evaporated by an evaporation device inside the vacuum chamber. The vapor cloud emanating from the evaporation device is directed through a vapor outlet of the evaporation device towards the substrate. The vapor outlet extends in a transverse direction relative to the longitudinal direction of the substrate. The vapor cloud emanating from the vapor outlet comprises a homogeneous spatial structure and a homogeneous vapor composition as seen in the transverse direction, i.e., perpendicular to the elongation of the metallic substrate.

The coating method further comprises the step of generating a plasma within a plasma zone at least by a first magnetron sputter source, such that the vapor cloud and the plasma zone at least partially overlap. Specifically, the vapor cloud has to traverse the plasma zone in order to reach the surface of the metallic substrate.

According to some examples the plasma is generated by the first magnetron sputter source and by a second magnetron sputter source. The first and the second magnetron sputter sources may be arranged at a well-defined distance as seen along the longitudinal extent of the metallic substrate. They may be offset in longitudinal direction relative to each other. The first magnetron sputter source and the second magnetron sputter source may be arranged and oriented parallel to each other.

The first and the second magnetron sputter sources may each comprise a rotatable sputter target with a respective axis of rotation extending in the transverse direction (y).

The evaporation device may be located longitudinally between the first magnetron sputter source and the second magnetron sputter source. The plasma and the plasma zone may extend from the first magnetron sputter source to the second magnetron sputter source. The plasma zone may be located between the first and second sputter sources and the substrate. The plasma zone or plasma may be further located or may extend between the vapor outlet of the evaporation device and the surface of the metallic substrate.

According to further examples the method of coating the metallic substrate is conducted by a coating arrangement as described above. Insofar, all features, effects and benefits as described above in connection with the coating arrangement equally apply to the method of coating of the metallic substrate; and vice versa.

According to a further example the method comprises the steps of generating a first sputter zone extending towards the substrate and including a first sputtered material extracted from a first rotatable sputter target of the first magnetron sputter source. The method further comprises generating a second sputter zone extending towards the substrate and including a second sputtered material extracted from a second rotatable sputter target of the second magnetron sputter source. The first and second sputtered material may be identical. In some examples the first and the second sputtered material and hence the first and the second sputter targets may comprise different sputter materials.

The material of the rotatable sputter target and hence the sputter material may distinguish from the evaporation material, which emanates from the vapor outlet in the vaporized state.

According to a further example the evaporation material comprises zinc (Zn). The first sputtered material comprises aluminum (Al) and the second sputtered material comprises one of magnesium (Mg) and titanium (Ti). Accordingly, and with the method there can be provided a multi-layer coating on the metallic substrate or a coating comprising a variance of its stoichiometric composition as seen along the surface normal of the coating on the metallic substrate.

According to a further example the metallic substrate comprises an elongated band of a high-strength steel, of a high-strength low-alloy steel, or a martensitic steel. The coating provided by the present coating method may comprise an anticorrosive coating.

Moreover and according to another aspect the present disclosure also relates to a coated metallic substrate, which has been coated by a method as described above. The transverse extent of the coated metallic substrate may range between 300 mm to 2,000 mm. The thickness of the substrate may range from 0.5 mm - 5 mm.

The strength or thickness of the coating or coating system may range from 1-100 µm. The strength or thickness of the coating or coating system may range from 1-100 µm. It may comprise a thickness between 1 µm and 20 µm, between 1 µm and 10 µm, between 2 µm and 10 µm or between 3 µm and 10 µm.

With a multilayer coating, and specifically with a multilayer coating comprising a first layer, a second layer and an optional third layer, e.g., the first layer layer and the outer layer, i.e., those layers made of or comprising at least one of aluminum, magnesium or titanium, may comprise a thickness that is less than 50%, less than 30%, less than 20%, less than 10%, less than 5%, or less than 2% of the overall thickness of the entire coating. Hence, the coating thickness may be dominated by the evaporation material.

In some examples, a single layer of the coating and hence that layer or a portion of the coating that is dominated by the evaporation material comprises a thickness of at least 50%, at least 70%, at least 80%, at least 90%, at least 95% or at least 98% of the overall thickness of the coating applied or coated on the metallic substrate.

According to some examples, the first layer, which is in direct contact with the substrate, may comprise aluminum or may be dominated by aluminum. It may comprise between 10%-100% of aluminum. It may comprise more than 50% or more than 80% of aluminum.

The third layer, which may form or constitute an outside layer of the coating system may comprise magnesium or may be dominated by magnesium. It may comprise between 10%-100% of magnesium. It may comprise more than 50% or more than 80% of magnesium.

The second layer, which may be located between the first layer and the second layer may comprise zinc or may be dominated by zinc. It may comprise between 10%-100% of zinc. It may comprise more than 50% or more than 80% of zinc. It may further comprise of up to 10% of aluminum or magnesium.

Such a coating composition is of particular benefit to provide a long-lasting anticorrosive effect on the metallic substrate with a high quality surface or surface finish.

### Brief Description of the Drawings

In the following, some examples of the coating arrangement and a method of coating a substrate are described in greater detail by making reference to the drawings, in which:
- Fig. 1: shows an example of a coating arrangement for coating a metallic substrate,
- Fig. 2: shows a cross-section through a coated metallic substrate,
- Fig. 3: shows a configuration of the coating arrangement,
- Fig. 4: shows another configuration of the coating arrangement,
- Fig. 5: shows a further configuration of the coating arrangement,
- Fig. 6: shows a further configuration of the coating arrangement,
- Fig. 7: is a perspective schematic illustration of the evaporation device and first and second magnetron sputter sources of the coating arrangement,
- Fig. 8: is a top view onto the coating arrangement according to Fig. 1-7,
- Fig. 9: is a further example of a coating arrangement in a perspective illustration,
- Fig. 10: is a top view of the configuration or example of Fig. 9,
- Fig. 11: shows another example of a coating arrangement for coating a vertically oriented metallic substrate,
- Fig. 12: is a flowchart of a method of coating a metallic substrate to be conducted with a coating arrangement as described herein,
- Fig. 13: shows a further coating arrangement with first and second evaporation devices on opposite sides of the metallic substrate as well as with numerous magnetron sputter sources on both sides of the metallic substrate and
- Fig. 14: shows a further coating arrangement with first and second evaporation devices on opposite sides of the metallic substrate as well as four magnetron sputter sources on both sides of the metallic substrate.

### Detailed description

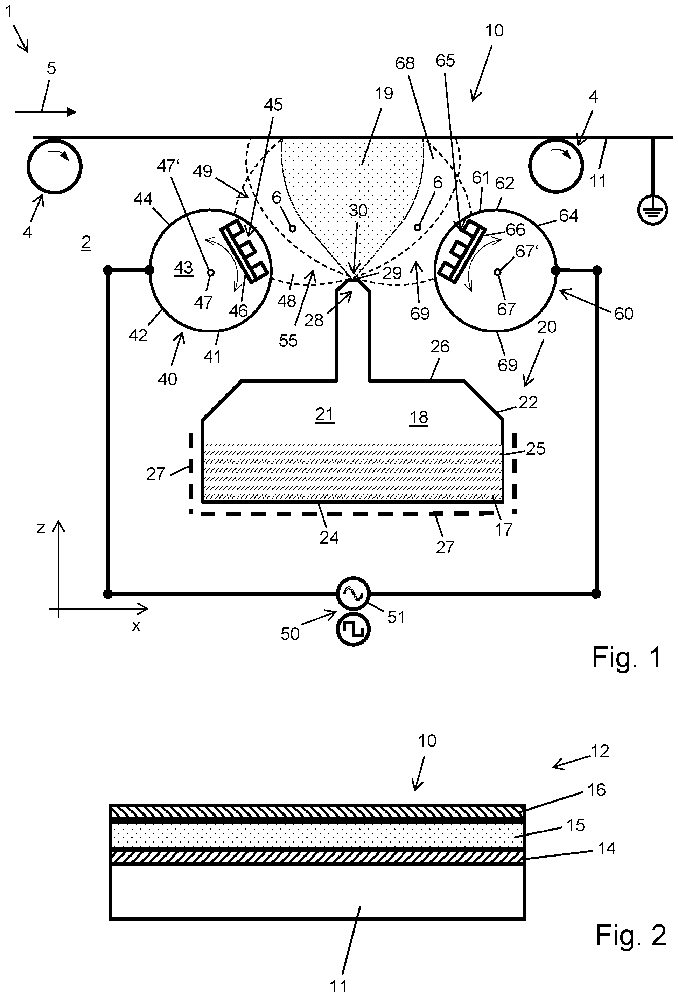

In Fig. 1 there is illustrated an example of a coating arrangement 1 for coating a metallic substrate 10. The coating arrangement 1 is arranged inside an evaporation chamber 2, which vacuum chamber 2 is held at a predefined vacuum pressure in accordance to predefined coating conditions suitable for coating of the metallic substrate 10.

The chamber walls are not explicitly illustrated in the figures. The coating arrangement 1 comprises an evaporation device 20, which is arranged inside the vacuum chamber 2 and which is configured to evaporate an evaporation material 17. The evaporation device 20 comprises a vapor outlet 28 facing towards the surface of the substrate 10. The evaporation device 20 is configured to generate a vapor cloud 19, emanating from the vapor outlet 28 and being directed towards and onto the surface of the metallic substrate 10.

The metallic substrate 10 may comprise an elongated band 11 of material. In some examples the coating arrangement 1 comprises a substrate transportation arrangement 4 by way of which the metallic substrate 10 can be moved along a longitudinal direction (x) relative to the evaporation device 20. The substrate transportation arrangement 4 is indicated by moving rollers but may be generally implemented in a variety of different ways generally known in the art of vapor deposition of metallic substrates.

The substrate transportation arrangement 4 may provide a continues movement of the metallic substrate 10 relative to the evaporation device 20 along the transport direction 5, which may coincide with the longitudinal direction of the metallic substrate 10.

The evaporation device 20 may comprise a heater 27, which is configured to provide thermal energy to an interior of the evaporation device 20 and/or to evaporate an evaporation material 17 located inside the evaporation device 20. The heater 27 may be in thermal contact with a housing 22 of the evaporation device 20. In some examples, the heater 27 may comprise a radiation heater or an inductive heater. Here, a direct thermal contact between the heater and the housing 22 of the evaporation device 20 may not be necessarily required.

The housing 22 of the evaporation device 20 encloses, encapsulates or confines an evaporation cavity 21. The housing 22 may comprise a bottom 24 and a sidewall 25 as well as a top wall 26 to enclose or to confine the evaporation cavity 21. The heating 27 may be in thermal contact with an outside or inside of the housing 22 so as to apply sufficient thermal energy into the housing 22 and hence into the evaporation cavity 21.

The evaporation material 17 may be provided or located in a meltable, molten, or liquid form inside the housing 22 of the evaporation device 20. The evaporation material 17 may be located inside the evaporation cavity 21. The evaporation material 17 may be located on the bottom 24 of the housing 22 of the evaporation device 20. By applying thermal energy to the evaporation material 17 the evaporation material will start to melt and/or to evaporate into the evaporation cavity 21. Accordingly, vaporized evaporation material and hence a respective vapor 18 may expand inside the evaporation cavity 21 and may leave the evaporation cavity 21 through the evaporation outlet 28, which may protrude outwardly from the top wall 26 or which may be provided in the top wall 26.

The evaporation outlet 28 may be provided with a nozzle 29 of well-defined size or geometry in order to provide a vapor distribution and hence a vapor cloud 19 of desired size, geometry and extent.

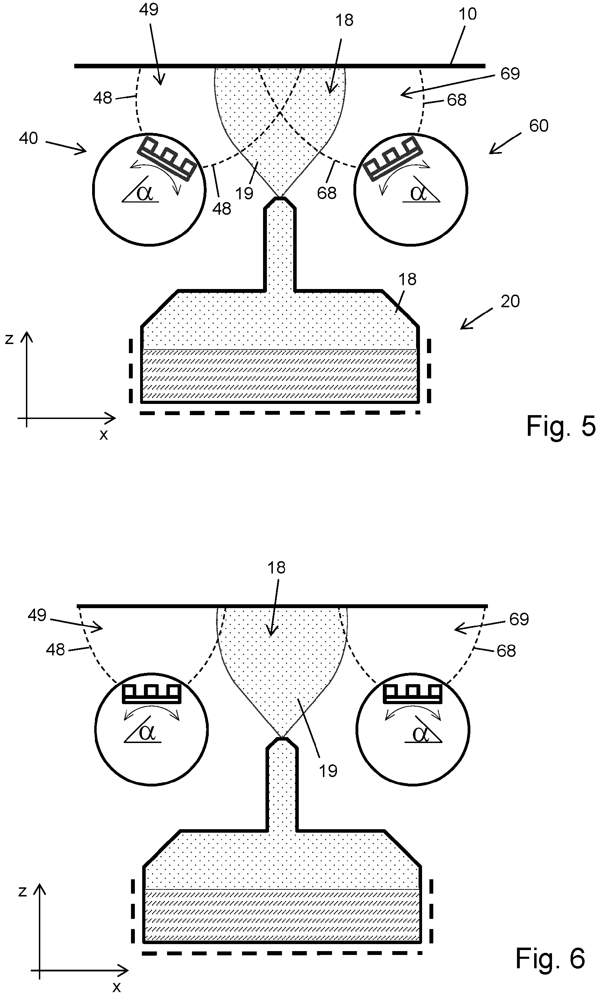

The vapor outlet 28, e.g. as illustrated in Figs. 1 - 7 may comprise an elongated continuous aperture 30 extending in the transverse direction (y), which transverse direction substantially extends perpendicular to the longitudinal direction (x) or transport direction (5) of the metallic substrate 10. Hence, the longitudinal direction (x) and the transverse direction (y) may extend parallel to or may coincide with the plane of the metallic substrate.

The evaporation outlet 28 may comprise a spatial vapor distributor or vapor distribution nozzle 29 by way of which the vapor 18 generated inside the evaporation cavity 21 can be guided and directed across and through the evaporation outlet 28 and hence through the respective evaporation aperture 30 towards the metallic substrate 10.

The elongation of the aperture 30 and hence of the nozzle 29 may correspond to the width of the metallic substrate and may hence correspond to the extent of the metallic substrate 10 as seen in the transverse direction (y). In this way, and by way of the geometric size an implementation of the vapor outlet 28 there can be provided a rather homogeneous vapor distribution across the width of the metallic substrate 10.

In the examples according to Figs. 1-8 the metallic substrate 10 is located above the vapor outlet 28. Accordingly, the metallic substrate 10 is coated from below and against the effect of gravity.

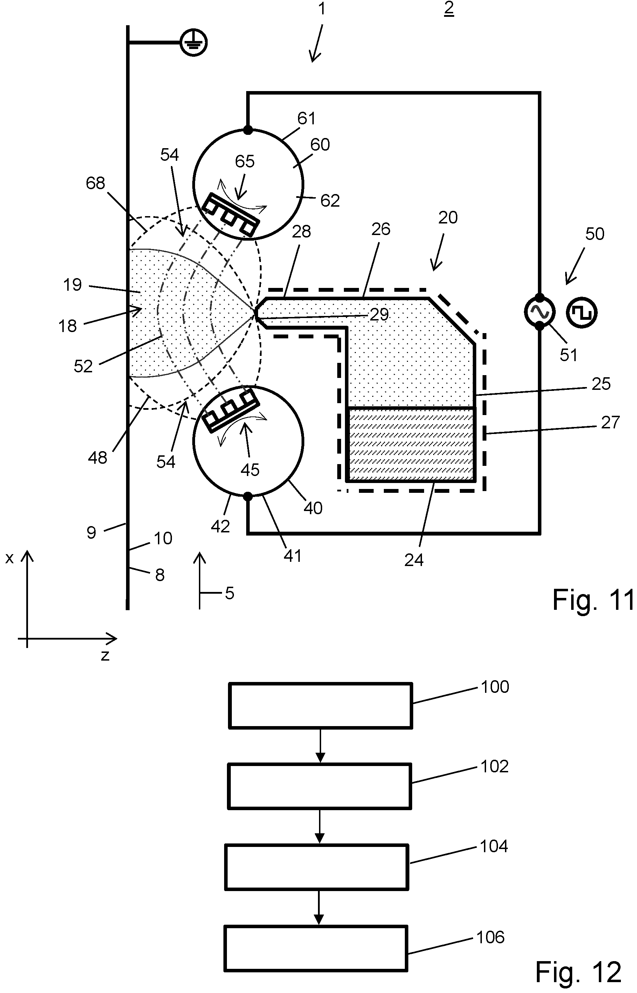

In other configurations as e.g. shown in Fig. 11 and 12 the metallic substrate 10 is oriented vertically and may be subject to a vertically directed transportation with respect to the direction of gravity. Here, the evaporation device 20 may be located at a horizontal offset from the surface of the metallic substrate and the vapor outlet 28 may be oriented horizontally. Here, the vapor cloud 19 may extend horizontally from the vapor outlet 28 towards and onto the vertically oriented metallic substrate 10.

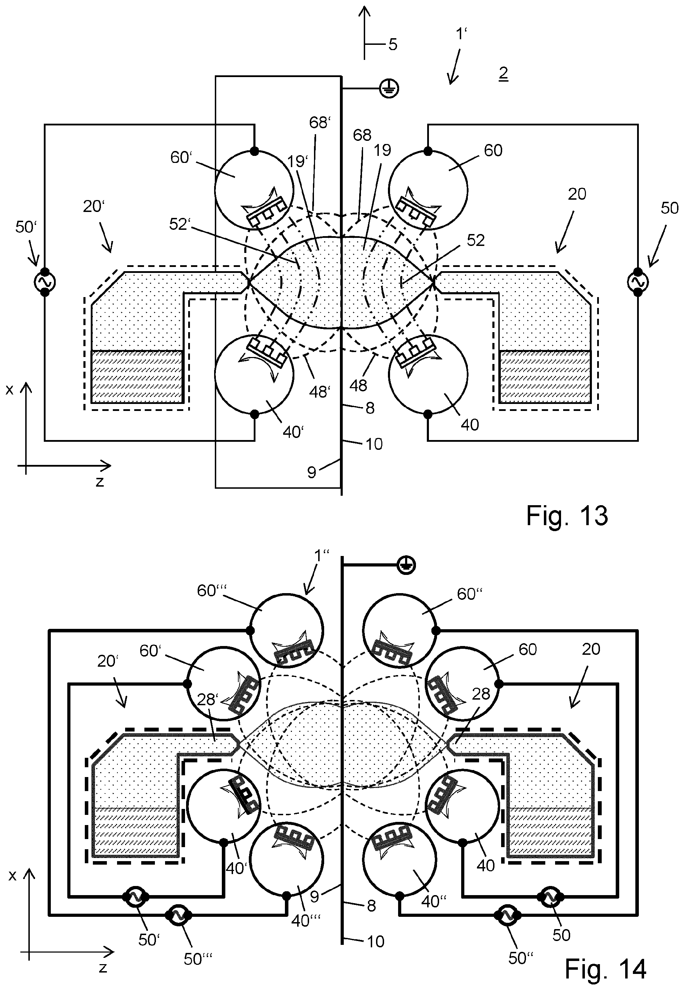

This arrangement allows for a double-sided simultaneous coating of the metallic substrate as indicated in Fig. 13.

Returning to the example of Fig. 1 the coating arrangement 1 further comprises a first magnetron sputter source 40 and a second magnetron sputter source 60. Generally, a single magnetron sputter source 40, 60 may be sufficient to generate a plasma 52 of a plasma material within a plasma zone 54 as illustrated in Fig. 11. With a first magnetron sputter source 40 and a second magnetron sputter source 60 the plasma 52 and the plasma zone 54 can be generated in a region extending from the first magnetron sputter source 40 to the second magnetron sputter source 60.

Here, the plasma 52 may be generated between the first and the second magnetron sputter sources 40, 60. For this, the first magnetron sputter source 40 comprises a first sputter target 41 and hence a first sputter electrode 44. Likewise, the second magnetron sputter source comprises a second sputter target 61 and a second sputter electrode 64. The first and the second sputter electrodes and 44, 64 are electrically connected to a power source 50, which may comprise an AC voltage generator 51. Accordingly, the sputter electrodes 44, 64 can be driven by an alternating voltage.

Here, the AC signals applied to the first and second sputter electrodes and 44, 64 may either comprise a sinusoidal type or may comprise one of bipolar or unipolar pulsed AC signal.

By way of the power source 50, the frequency, the amplitude, the pulse duration and the pulse intervals can be modified and controlled in order to modify and/or to control the composition, the density, the direction and the spatial extent of the plasma 52 and the plasma zone 54.

The plasma 52 is typically generated with an inert gas, as a plasma material, which is supplied into the evaporation chamber 2 by a gas supply 6. The inert gas located between the first and second sputter electrodes 44 provides a plasma material on the basis of which the plasma 52 and the plasma zone 54 will be generated as soon the first and the second electrodes 44, 64 are driven with respective AC power.

The first and second magnetron sputter sources 40, 60 may comprise a somewhat identical or mutually corresponding structure. The first magnetron sputter source 40 comprises a hollow elongated sleeve 42 with a hollow interior 43. Inside the hollow interior 43 there is arranged a first magnet arrangement 45 comprising numerous permanent magnets and a carrier 46. The magnet arrangement is arranged and fixed to the carrier 46, which is movable or tiltable inside the interior 43 of the hollow elongated sleeve 42. The sleeve 42 comprises a central axis, which may coincide with a rotation axis 47 of the sleeve 42.

The sleeve 42 may comprise or constitute the sputter target 41. The sputter target 41 may be rotatable with respect to the rotation axis 47 and hence with respect to the center axis of the elongated sleeve 42. The rotation axis 47 and hence the center axis of the sleeve 42 may extend in the transverse direction (y) and hence parallel to the elongation of the vapor outlet 28 and/or of the nozzle 29 and its aperture 30.

The carrier 46 and hence the magnet arrangement 45 may be tiltable with respect to a tilt axes 47'. In the presently illustrated example the tilt axis 47' may coincide with the rotation axis 47. The rotation axis 47 defines a rotation axis with respect to which the first sputter target 41 and hence the sleeve 42 may rotate during the coating process.

Accordingly, the first magnetron sputter source 40 comprises a rotatable magnetron sputter source with a rotating sputter target 41 and hence with a rotating first electrode 44. The magnet arrangement 45 may be movable or tiltable relative to the electrode 44. The tilt axis 47' may be also located at a predefined offset from the rotation axis 47 of the sputter target 41 or sputter electrode 44. By moving or tilting the carrier 46 and hence the magnet arrangement 45 the orientation of the respective magnetic field 55 can be varied, which in effect leads to a respective variation of the extent, the size and the location of the resulting plasma zone 54.

The magnetic field 55 as provided by the first magnet arrangement 45 serves to force the electrons of the plasma 52 onto a helical path by way of which the electrons of the plasma material, e.g., of the inert gas, such as argon, collide with organ ions, which in turn impinge on the surface of the sputter target 41 by way of which respective sputter material is released and extracted from the surface of the sputter target 41 into a sputter zone 48.

Depending on the orientation and strength of the magnetic field 55, the size, shape and orientation of the sputter zone 48 generated by the first magnetron sputter source 40 can be adjusted. Accordingly, the first magnetic sputter source 40 is configured to generate or to provide a sputter zone 48 of a first sputter material 49, which is released due to the sputtering of the first sputter target 41. Likewise, the second magnetron sputter source 60 is configured to generate a second sputter zone 68 of a second sputter material 69 that has been released or sputtered from the second sputter target 61.

By varying the angular orientation of the tilt angle α of the magnet arrangement 45, 65 of the respective first and second magnetron sputter sources 40, 60, the degree of overlapping between the plasma zone 54 with the vapor cloud 19 as well as the degree of overlapping between one of the plasma zone 54 and the vapor cloud 19 with the first sputter zone 48 and/or with the second sputter zone 68 can be modified and adjusted to provide a coating of desired composition and desired properties on the metallic substrate 10.

The magnet arrangements 45, 65 may be mutually adjusted and may mutually magnetically interact to generate a common magnetic field or magnetic field distribution between the first magnetron sputter source 40 and the second magnetron sputter source 60.

Here, and with multiple magnetrons system, the magnetic fields can be arranged with either identical, or opposite magnetic polarities. Accordingly, the magnet arrangements 45, 65 may be either in a "mirrored-field" configuration, or "closed-field" configuration. In the mirrored-field configuration, where the field lines diverge to the vacuum chamber walls, there may be provided a comparatively low plasma density around the substrate. In the closed-field configuration the magnetic field lines are linked between the magnet arrangement 45, 65, and hence between the magnetron sputter sources 40, 60. This may lead to a comparatively high density plasma region around the substrate.

Moreover, the first and the second magnet arrangements 45, 65 may be either implemented or configured as one of a balanced magnet arrangement 45, 65 and an unbalanced magnet arrangement 45, 65. Unbalanced magnetrons have a "leaky" magnetic field, in the sense that not all the field lines are closed between the central and outer poles of the respective magnet arrangement 45, 65. Here, some magnetic field lines may extend to the substrate. Consequently, the plasma may also extends towards the substrate, leading to high ion currents directed to the substrate.

According to some examples, both of the magnet arrangements 45, 65 may be unbalanced and may be mutually arranged in a closed field configuration.

In some examples it may be provided that the first sputter zone 48 comprises a first sputter material 49 so as to generate a first layer 14 on the band 11 of the substrate 10 as indicated in Fig. 2. With respect to the substrate transport direction 5 the first sputter zone 48 may precede the vapor cloud 19. Moreover, and as seen along the transport direction 5, the vapor cloud 19 may precede the second sputter zone 68. In this way there can be provided a multilayer coating 12 on the band 11 of the substrate 10 as indicated in Fig. 2.

The first layer 14 may be dominated by the first sputter material 49. The second layer 15 may be dominated by the evaporation material 17 that is deposited onto the substrate through the vapor cloud 19 and the final and upper layer 16 may be provided or dominated by the second sputter material 69 deposited onto the substrate 10 by way of the second magnetron sputter source 60 and the second sputter zone 68.

Tilting or reorienting the first and the second magnet arrangements 45, 65 inside the respective hollow interiors 43, 63 of the respective first and second sputter targets 41, 61 or sputter electrodes 44, 64 allows to modify the spatial extent, the spatial distribution and geometric constitution of the vapor cloud 19, the first sputter zone 48, the second sputter zone 68, and the plasma zone 54, respectively.

Also the second magnetron sputter source 60 comprises a 66 with a magnet arrangement 65, which is movable or tiltable with respect to a tilt axes 67'. In the presently illustrated example the tilt axis 67' may coincide with the rotation axis 67. The rotation axis 67 defines a rotation axis with respect to which the second sputter target 61 and hence the sleeve 62 of the second sputter source 60 may rotate during the coating process.

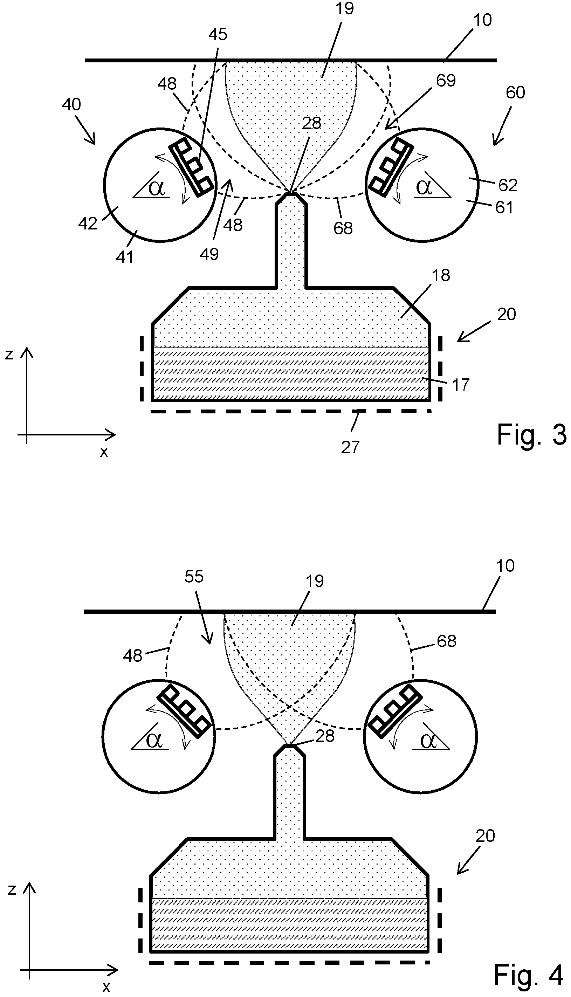

The effect of the numerous varying orientations of the magnet arrangements 45, 65 with respect to the longitudinal direction (x) and hence variation of tilt angle α of the magnet arrangements 45, 65 relative to the substrate surface as shown in Figs. 3-6 leads to different degrees of mutual overlapping between the vapor cloud 19, the plasma zone 54 and the sputter zones 48, 68. In this way, the stoichiometric composition of the coating 12 as well as further properties of the coating, i.e., the surface quality, the coating density and thickness of the coating or coating composition can be adjusted and controlled.

Moreover, and since the first and second magnetron sputter sources 40, 60 also comprise a constant cross-section and hence a homogeneous structure as seen in transverse direction (y) the respective sputter zones 48, 68 as well as the plasma zone 54 located between the first and the second magnetron sputter sources 40, 60 are highly homogeneous in the transverse direction (y).

Accordingly, the coating 12 on the metallic substrate 10 as seen in the transverse direction (y) comprises a high degree of homogeneity. Moreover, the process of coating a metallic substrate can be rather easily controlled by the first and second magnetron sputter sources 40, 60 and by the evaporation device 20.

The rotatable sputter targets 41, 61 are beneficial to avoid any redeposition of sputtered material on the respective sputter targets 41, 61 or sputter electrodes 44, 64. Moreover and since the rotatable magnetrons 40, 60 comprise a respective movable or tiltable magnet arrangement 45, 65 inside the protected interior 43, 63 of the respective tubular sleeves 42, 62, the spatial extent and orientation of the plasma zone 54 as well as of the sputter zones 48, 68 can be modified and controlled without the necessity to vary or adjust the position of the magnetron sputter sources 40, 60 relative to each other, relative to the substrate 10 or relative to the evaporation device 20. Insofar, there can be provided an in-site control and/or modification of the plasma zone 54, of the first sputter zone 48 and of the second sputter zone 68, respectively.

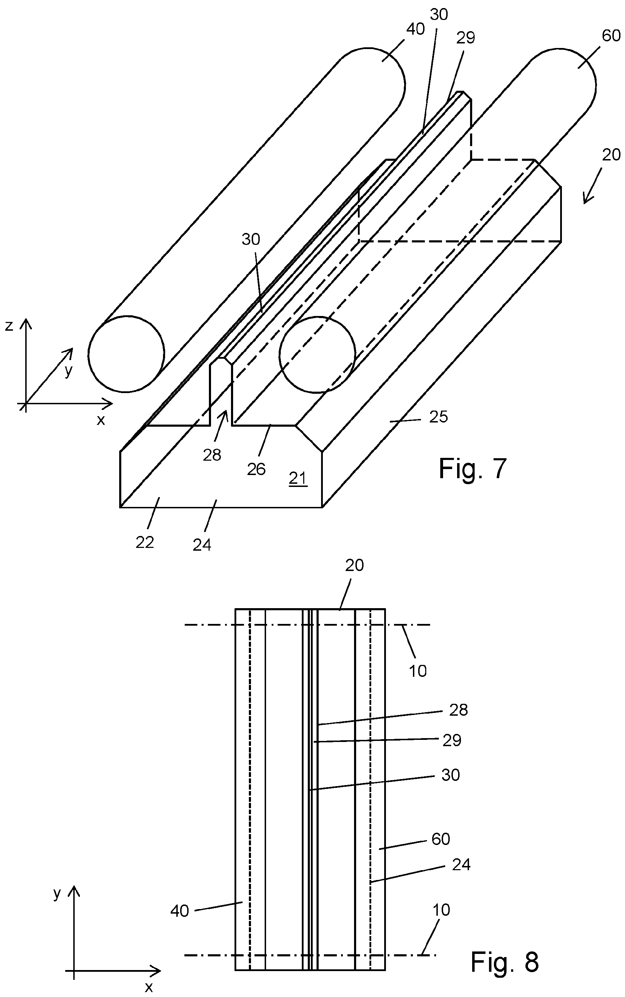

As it is particularly apparent from Fig. 8, the transverse extent of the substrate 10 is substantially equivalent or corresponds to the respective transverse extent of the vapor outlet 28 as well as the transverse extent of the first and second magnetron sputter sources 40, 60. In this way there can be provided a highly homogeneous coating 12 on the substrate 10 as seen in the transverse direction (y).

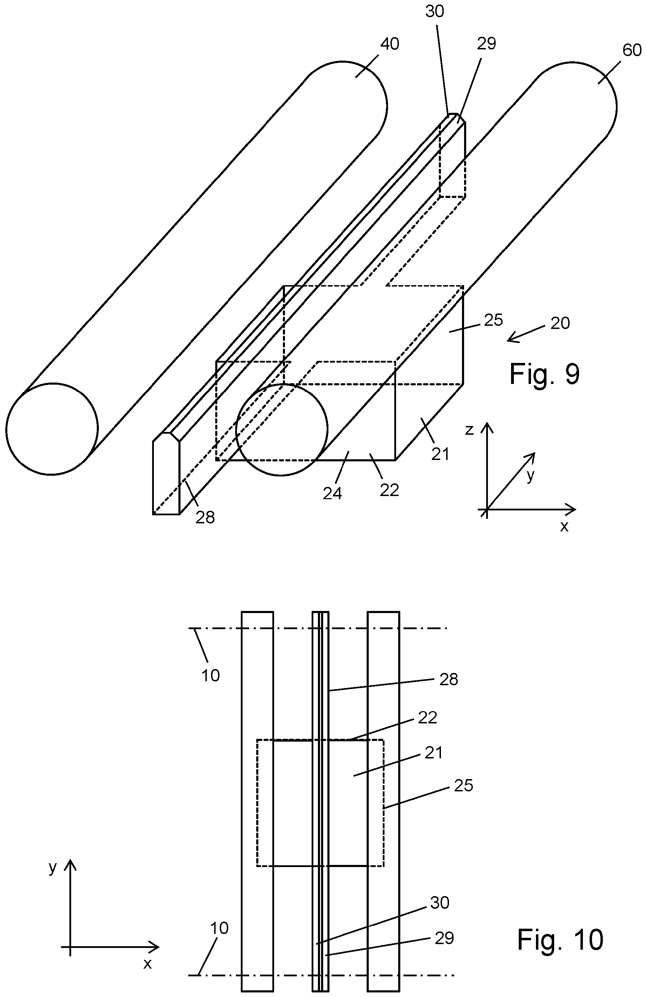

The vapor outlet 28 of the evaporation device 20 is dimensioned in accordance to the respective extent of the metallic substrate 10. In general, the housing 22 of the evaporation device 20 does not have to extend over the entire transverse width of the metallic substrate. In the example of Fig. 9, the housing 22 comprises or forms an evaporation cavity 21 confined by the bottom 24 and the sidewall 25 that is smaller compared to the transverse extent of the evaporation outlet 28. Here, the evaporation outlet 28 may be provided on top of the sidewall 25 and/or may protrude outwardly fro the top wall 26 and may protrude in transverse direction from the sidewall 25 so as to form or to constitute a spatial vapor distributor of appropriate size to provide a homogeneous vapor cloud 19 with a sufficient and desired transverse or lateral extent.

With the further examples of the coating arrangement 1 according to Figs. 11, 13 and 14 the metallic substrate 10 is oriented vertically. Here, the longitudinal direction (x) of the metallic substrate 10 extends in a vertical direction and the entire coating arrangement 1, i.e., the evaporation device 20 and the first and second magnetron sputter sources 40, 60 are arranged at a respective vertical offset from each other. They are separated horizontally from a first side 8 of the substrate 10. Also here, there will be established a plasma zone 54 between the first and the second magnetron sputter sources 40, 60 with the evaporation device 20, i.e., with the vapor outlet 28 of the evaporation device 20 located between the first and the second magnetron sputter sources 40, 60 as seen along the longitudinal extend or longitudinal direction (x) of the metallic substrate.

Here, the vapor outlet 28 may protrude or extend from the sidewall 25 of the housing of the evaporation device 20 at or near the top wall 26 of the housing 22. As illustrated in Fig. 11, the vapor cloud 19 extends horizontally from the vapor outlet 28 towards and onto the surface of the substrate 10. With the coating arrangement 1 as shown in Fig. 11 the first side 8 of the substrate 10 can be treated or coated in a way as described above.

Also here, the metallic substrate 10 may be subject to a continuous movement along the vertical direction, e.g., upwardly.

The vertical orientation of the substrate 10 allows to treat and/or to coat both sides 8, 9 of the substrate 10 simultaneously or in a temporarily overlapping manner. For this, the coating arrangement 1' as illustrated in Fig. 13 comprises a first and a second evaporation device 20, 20' arranged on opposite sides 8, 9 of the substrate 10. The vapor outlet 28 of the evaporation device 20 faces towards the first substrate side 8. The evaporation outlet 28' of the further evaporation device 20' faces towards the opposite and hence to a second side 9 of the substrate 10. The evaporation device 20 is configured to produce and to provide a vapor cloud 19 extending towards the first side 8 of the substrate 10. The further evaporation device 20' is configured to produce and to provide a further vapor cloud 19' extending towards the opposite and hence to the second side 9 of the substrate 10.

The evaporation device 20 is further associated with a first magnetron sputter source 40 and a second magnetron sputter source 60, which are located adjacent to both sides of the vapor outlet 28 as seen in longitudinal direction, i.e., along the transport direction 5 of the metallic substrate 10. The further evaporation device 20' is provided with two further magnetron sputter sources 40', 60'. In this way there can be provided substantially equal or different coating or treatment conditions for both sides 8, 9 of the substrate 10 in a simultaneous manner.

The first magnetron sputter sources 40, 40' may be configured to direct a respective first sputter material 49 via first sputter zones 48, 48' onto the opposite sides 8, 9 of the substrate 10. The evaporation devices 20, 20' are configured to provide oppositely located vapor cloud 19, 19' onto opposite sides 8, 9 of the substrate 10 and the second magnetron sputter sources 60, 60' are capable and/or configured to provide a second sputter material 69 through respective second sputter zones 68, 68' onto opposite sides of the substrate 8, 9. In this way, a general throughput and coating efficiency as provided by the coating arrangement 1' can be improved and enhanced.

In Fig. 14, there is illustrated a further example of the coating arrangement 1", which may include the coating arrangement 1' according to Fig. 13. In addition to the coating arrangement 1' of Fig. 13, the further variant of the coating arrangement 1" of Fig. 14 is provided with four supplemental magnetron sputter sources 40", 60", 40‴ and 60"'. Here, the coating arrangement 1" comprises 8 magnetron sputter sources altogether.

Here, on each side 8, 9 of the substrate 10 there are provided altogether four magnetron sputter sources. The sputter sources 40, 60, 40" and 60" may be arranged on the first side 8 of the substrate 10. The further sputter sources 40', 60', 40‴ and 60‴ may be arranged on the opposite second side 9 of the substrate 10.

The magnetron sputter sources 40, 60 may be arranged adjacent to the first evaporation device 20. They may be arranged or located below and above the vapor outlet 28. The further magnetron sputter sources 40" and 60" may be located adjacent to the sputter sources 40, 60. E.g., the sputter source 60" may be arranged adjacent to the sputter source 60. The sputter source 60 may be arranged between the sputter source 60" and the evaporation device 20. Likewise, the sputter source 40" may be arranged adjacent to the sputter source 40. The sputter source 40 may be arranged between the sputter source 40" and the evaporation device 20.

In a similar manner, the magnetron sputter sources 40', 60' may be arranged adjacent to the second evaporation device 20'. They may be arranged or located below and above the respective vapor outlet 28'. The further magnetron sputter sources 40‴ and 60‴ may be located adjacent to the sputter sources 40', 60'. E.g., the sputter source 60‴ may be arranged adjacent to the sputter source 60'. The sputter source 60' may be arranged between the sputter source 60‴ and the evaporation device 20'. Likewise, the sputter source 40‴ may be arranged adjacent to the sputter source 40'. The sputter source 40' may be arranged between the sputter source 40‴ and the evaporation device 20.

The magnetron sputter sources 40, 40', the magnetron sputter sources 40", 40‴, the magnetron sputter sources 60, 60' and the magnetron sputter sources 60", 60‴ may be pairwise provided with the same sputter material. In this way, there can be provided identical coatings 12 or coating systems on both sides 8, 9 of the substrate 10.

The sputter materials of the magnetron sputter sources located on the same side of the substrate 10 may be different. Hence, the sputter material of the magnetron sputter source 40 may distinguish from the sputter material of the magnetron sputter source 60. The sputter material of the magnetron sputter source 40" may be identical to or may distinguish from the sputter material of the magnetron sputter source 40. The sputter material of the magnetron sputter source 60" maybe identical to or may distinguish from the sputter material of the magnetron sputter source 60. The sputter material of the magnetron sputter source 60" may be identical to or may distinguish from the sputter material of the magnetron sputter source 40". A similar or like configuration may apply to the sputter materials of the magnetron sputter sources 60', 40', 60‴ and 40‴.

The magnetron sputter sources as illustrated in Fig. 14 might be pairwise electrically coupled or connected and hence driven by a number of power sources 50, 50', 50", 50‴. A power source 50 may be operable to supply a driving voltage or driving current to the magnetron sputter sources 40, 60. The power source 50" may be coupled to the magnetron sputter sources 40", 60". Likewise, the power source 50' is electrically coupled to the magnetron sputter sources 40', 60' and the power source 50‴ is electrically coupled to the further magnetron sputter sources 40"', 60‴.

By way of a comparatively large number of magnetron sputter sources, the overall coating process for the substrate 10 can be individually adjusted, both in terms of a material composition of the coatings or coating systems and with respect to the generation, composition, position, density, size and geometric shape of a plasma 52 in the plasma zone 54 for coating the substrate 10.

Of course, the arrangement of four magnetron sputter sources 40, 60, 40", 60" may be also applicable to or may be implemented with a coating arrangement 1, which is configured for a single-sided coating of the substrate 10. Likewise, a coating arrangement with four magnetron sputter sources on one side of the substrate 10 may be also implemented in a horizontal orientation, such as illustrated in any of the Figs. 1-6, where the substrate 10 is oriented horizontally.

The flowchart according to Fig. 12 illustrates numerous steps of coating a metallic substrate 10, e.g., by making use of a coating arrangement 1 or 1' as described herein. In a first step 100 there is provided a metallic substrate 10 in a vacuum chamber 2 of the coating arrangement 1. In step 102 evaporation material as provided by an evaporation device 20 inside the vacuum chamber 2 is directed via a vapor cloud 19 through a vapor outlet 28 of the evaporation device 20 towards the surface of the substrate 10.

Here, the vapor outlet 28 and hence the vapor cloud 19 extends in a transverse direction (y) relative to the longitudinal direction (x). Accordingly, the vapor cloud 19 exhibits a rather homogeneous composition and spatial distribution as seen in the transverse direction. In step 104 there is generated a plasma 52 within a plasma zone 54 at least by a first magnetron sputter source 40, such that the vapor cloud 19 and the plasma zone 54 at least partially overlap.

In step 106 there may be optionally used a second magnetron sputter source 60 to generate the plasma, e.g., between the first and the second magnetron plasma sources 40, 60 such that the vapor cloud 19 has to traverse or to penetrate the plasma zone 54 and the plasma 52.

By way of the first and second magnetron sputter sources 40, 60 there can be also provided first and second sputter zones 48, 68 by way of which respective first and second sputter material 49, 69 can be deposited on the surface of the substrate 10.

The first magnetron sputter source may be arranged longitudinally adjacent to the evaporation device 20 such the respective first sputter zone 48 precedes the region of the substrate 10 that is exposed to the vapor cloud 19 and the respective vapor 18 as produced and provided by the evaporation device 20. The second magnetron sputter source 60 may be located and arranged at a longitudinal offset as seen in the transport direction 5 from the evaporation device 20, such that the vapor outlet 28 of the evaporation device 20 precedes the second sputter zone 68 as seen along the longitudinal direction (x) or transport direction 5 of the metallic substrate 10. In this way there can be generated and provided a multilayer coating 12 on the metallic substrate 10.

In some examples the first magnetron sputter source 40 comprises a first sputter target 41 comprising aluminum. The second magnetron sputter source 60 may comprise a sputter target 61 comprising magnesium. The evaporation material 17 vaporized by the evaporation device 20 may comprise zinc.

In this way the multilayer structure of the coating 12 as indicated in Fig. 2, which can be produced or provided by the coating arrangement 1 as described herein, may comprise a first layer 14 comprising aluminum or being dominated by aluminum. The second layer 15 may comprise zinc or may be dominated by zinc and the third or top layer 16 may comprise one of magnesium and titanium or may be dominated by one of magnesium and titanium.

The individual layers 14, 15, 16 are only exemplary. By way of using first and second magnetron sputter sources 40, 60 in combination with an evaporation device 20 there may be rather smooth transitions between the individual layers 14, 15, 16. Hence, across the thickness of the coating 12 there may be provided a smooth variation of the stoichiometric geometric composition of the multilayer structure or multi-material structure of the coating 12, which may be beneficial to improve the durability, mechanical and chemical resistivity and anticorrosive capabilities of the coating 12 on the metallic substrate 10.

Moreover, by combining the process of sputter deposition by way of the first and second magnetron sputter sources 40, 60 with a physical vapor deposition as provided by the evaporation device 20 the overall process temperature and hence the temperature to which the substrate 10 is exposed to during the coating process can be kept at a comparatively low level, e.g. in the region below 300°C, below 250°C or below 200°C. This is of particular benefit when using metallic substrates that are rather sensitive to heat or to thermal loads, such as high-strength steel or martensitic steel.

### Reference Numbers

- 1: coating arrangement
- 2: evaporation chamber
- 4: substrate transportation arrangement
- 5: transport direction
- 6: gas supply
- 8: substrate side
- 9: substrate side
- 10: substrate
- 11: band
- 12: coating
- 14: layer
- 15: layer
- 16: layer
- 17: evaporation material
- 18: vapor
- 19: vapor cloud
- 20: evaporation device
- 21: evaporation cavity
- 22: housing
- 24: bottom
- 25: sidewall
- 26: top wall
- 27: heating
- 28: outlet
- 29: nozzle
- 30: aperture
- 40: magnetron sputter source
- 41: sputter target
- 42: sleeve
- 43: interior
- 44: electrode
- 45: magnet arrangement
- 46: carrier
- 47: rotation axis
- 47': tilt axis
- 48: sputter zone
- 49: sputter material
- 50: power source
- 51: AC voltage generator
- 52: plasma
- 54: plasma zone
- 55: magnetic field
- 60: magnetron sputter source
- 61: sputter target
- 62: sleeve
- 63: interior
- 64: electrode
- 65: magnet arrangement
- 66: carrier
- 67: rotation axis
- 67': tilt axis
- 68: sputter zone
- 69: sputter material

## Claims

1. A coating arrangement (1) for coating a metallic substrate (10) extending along a longitudinal direction (x), the coating arrangement (1) comprising:
- a vacuum chamber (2) to receive the metallic substrate (10),
- an evaporation device (20) arranged inside the vacuum chamber (2) and configured to evaporate an evaporation material (17), the evaporation device (20) comprising a vapor outlet (28) extending in a transverse direction (y) relative to the longitudinal direction (x) to direct a vapor cloud (19) towards the substrate (10),
- a first magnetron sputter source (40) arranged inside the vacuum chamber (2) longitudinally adjacent to the vapor outlet (28) and configured to generate a plasma (52) of a plasma material within a plasma zone (54), and
- wherein the evaporation device (20) and the first magnetron sputter source (40) are configured such, that the vapor cloud (19) and the plasma zone (54) at least partially overlap.

2. The coating arrangement (1) according to claim 1, wherein the evaporation device (20) comprises a housing (22) confining an evaporation cavity (21) and wherein the vapor outlet (28) comprises an elongated nozzle (29), which is in flow communication with the evaporation cavity (21) and which extends in the transverse direction (y).

3. The coating arrangement (1) according to any one of the preceding claims, wherein the first magnetron sputter source (40) comprises a hollow tubular sleeve (42) with a sleeve axis extending in the transverse direction (y).

4. The coating arrangement (1) according to any one of the preceding claims, wherein the first magnetron sputter source (40) comprises a first rotatable sputter target (41), which is rotatable with respect to a first axis of rotation (47) extending in the transverse direction (y).

5. The coating arrangement (1) according to claim 3 or 4, wherein the first magnetron sputter source (40) comprises a first magnet arrangement (45) inside the first rotatable sputter target (41) and/or inside the hollow tubular sleeve (42).

6. The coating arrangement (1) according to claim 5, wherein the magnet arrangement is rotatable or tiltable relative to at least one of the first rotatable sputter target (41) and the hollow tubular sleeve (42) with respect to a tilt axis (47') extending in the transverse direction (y).

7. The coating arrangement (1) according to any one of the preceding claims 3 - 6, wherein the first rotatable sputter target (41) comprises a first sputter material (49) and wherein the first magnetron sputter source (40) is configured to generate a first sputter zone (48) extending towards the substrate (10) and including first sputtered material (49) extracted from the first rotatable sputter target (41).

8. The coating arrangement (1) according to any one of the preceding claims, further comprising a second magnetron sputter source (60) arranged inside the vacuum chamber (2) longitudinally adjacent to the vapor outlet (28) such that the vapor outlet (28) is located longitudinally between the first magnetron sputter source (40) and the second magnetron sputter source (60).

9. The coating arrangement (1) according to claim 8, wherein a first electrode (44) of the first magnetron sputter source (40) and a second electrode (64) of the second magnetron sputter source (60) are electrically coupled to an AC power source (50) to generate an electrical field of alternating polarity between the first electrode (44) and the second electrode (64).

10. The coating arrangement (1) according to claim 8 or 9, wherein the second magnetron sputter source (60) comprises a second sputter target (61) comprising a second sputter material (69), which distinguishes from the first sputter material (49) of the first magnetron sputter source (40).

11. The coating arrangement (1) according to any one of the preceding claims, wherein a transverse extent of at least one of the vapor outlet (28) and the magnetron sputter source (40, 60) corresponds to a transverse extent of the substrate (10).

12. The coating arrangement (1) according to any one of the preceding claims, further comprising a substrate transportation arrangement (4) to continuously move the substrate (10) along the longitudinal direction (x).

13. A method of coating a metallic substrate (10) extending along a longitudinal direction (x) by using a coating arrangement (1), the method comprising the steps of:
- supplying the metallic substrate (10) into a vacuum chamber (2) of the coating arrangement (1),
- evaporating an evaporation material (17) by an evaporation device (20) inside the vacuum chamber (2) and directing a vapor cloud (19) through a vapor outlet (28) of the evaporation device (20), towards the substrate (10), wherein the vapor outlet (28) extends in a transverse direction (y) relative to the longitudinal direction (x),
- generating a plasma (52) within a plasma zone (54) at least by a first magnetron sputter source (40) such that the vapor cloud (19) and the plasma zone (54) at least partially overlap.

14. The method according to claim 13, further comprising the step of generating the plasma (52) by the first magnetron sputter source (40) and by a second magnetron sputter source (60).

15. The method according to claim 14, and further comprising the steps of:
- generating a first sputter zone (48) extending towards the substrate (10) and including a first sputtered material (49) extracted from a first rotatable sputter target (41) of the first magnetron sputter source (40) and
- generating a second sputter zone (68) extending towards the substrate (10) and including a second sputtered material (69) extracted from a second rotatable sputter target (61) of the second magnetron sputter source (60).
